# EUROPEAN PATENT SPECIFICATION

(11) **EP 4 529 360 B1**
(45) Date of publication and mention of the grant of the patent: **09.12.2026**
(21) Application number: 23879062.0
(22) Date of filing: 16.10.2023
(51) Int. Cl.: H05F 3/02, G09F 9/30, H05K 9/00

(54) **TERMINAL FRAME AND TERMINAL DEVICE**
ENDGERÄTERAHMEN UND ENDGERÄTEVORRICHTUNG
CADRE DE TERMINAL ET DISPOSITIF TERMINAL

(30) Priority: 18.10.2022 CN 202211275224
(43) Date of publication of application: 26.03.2025
(73) Proprietor: Huawei Technologies Co., Ltd., Shenzhen, Guangdong 518129 (CN)
(72) Inventor: LU, Liang, Shenzhen, Guangdong 518129 (CN); YU, Junfeng, Shenzhen, Guangdong 518129 (CN); CAO, Zhangshuai, Shenzhen, Guangdong 518129 (CN); LIU, Yao, Shenzhen, Guangdong 518129 (CN); MA, Jiandong, Shenzhen, Guangdong 518129 (CN); ZHANG, Yun, Shenzhen, Guangdong 518129 (CN)
(74) Representative: Maiwald GmbH
(86) International application number: PCT/CN2023/124721
(87) International publication number: WO 2024/083073

(56) References cited:
- CN-A- 108 023 978
- CN-B- 113 710 030
- CN-U- 203 643 704
- CN-U- 203 643 704
- CN-U- 212 723 587
- CN-U- 216 052 515
- KR-B1- 101 704 644
- US-A1- 2017 135 188
- US-A1- 2020 162 591

## Description

### TECHNICAL FIELD

This application relates to the field of terminal device anti-static technologies, and in particular, to a terminal frame body and a terminal device.

### BACKGROUND

Electrostatic discharge (ESD, Electrostatic Discharge) refers to transfer of electrostatic charges between objects or surfaces with different electrostatic potentials. During use of a terminal such as a mobile phone, due to long-time friction, especially friction on a metal side or a plastic side, an electrostatic discharge problem occurs on a screen side. If static electricity occurs in a terminal device and a charge is not transferred to a safety component region, a sensitive component (such as a screen) may fail, causing component damage and causing a functional problem such as a failure of the terminal device.

Currently, for an electrostatic discharge problem of a terminal device such as a mobile phone, to prevent a charge generated due to friction on a side or the like from being transferred to a sensitive component such as a screen, glue dispensing is usually performed between the screen and a plastic middle frame, to prevent the charge on the side from being transferred to the screen. The glue dispensing causes an increase in a thickness of the terminal such as the mobile phone.

Chinese utility model CN 203643704 U describes a liquid crystal module with an electrostatic protection function comprising a liquid crystal panel, an insulating front frame, an insulating middle frame matched with the front frame to fix the liquid crystal panel and a metal back panel arranged at the back side of the front frame.

### SUMMARY

This application provides a terminal frame body and a terminal device. A conductor is disposed, so that when an electrostatic charge is generated on an outer edge of the terminal device, the conductor can intercept the electrostatic charge in time, and conduct the electrostatic charge to a grounding electrode such as an antenna for charge balance. In addition, a structure change is small, and a size and mass of the terminal device do not increase to a large extent. In a size design of the terminal device, improvement in a structure and a size of the terminal frame body is not affected, and the structure of the terminal frame body can be standardized, to facilitate production and assembly of the terminal device.

The invention is set out in the appended set of claims.

According to a first aspect, this application provides a terminal frame body, configured to connect a display to a grounding electrode in a terminal device, and including a frame body and a conductor, where a first assembly surface and a second assembly surface are provided on the frame body, the first assembly surface is configured to: connect to an outer edge of the display, and form an assembly gap, and the second assembly surface is configured to connect to the grounding electrode; an electron isolation part is disposed between the first assembly surface and the second assembly surface, the electron isolation part is close to the assembly gap, the electron isolation part is at least a part of the frame body, a cavity is provided in the electron isolation part, and the conductor is located in the cavity; and the conductor is partially located in the assembly gap or is in a spaced connection to the assembly gap, and the conductor is in a contact connection to or is in a spaced connection to the grounding electrode.

The terminal frame body in this implementation can connect the display to the grounding electrode. When an electrostatic charge is generated at an outer edge of the terminal device, and the electrostatic charge is conducted to an inner side of the display along the assembly gap, or the electrostatic charge is conducted to an inner side of the display through a part of the frame body, the conductor can intercept the electrostatic charge in time, and conduct the electrostatic charge to the grounding electrode such as an antenna for charge balance. A volume of the terminal frame body described in this application does not change, a structure change is small, and a size and mass of the terminal device do not increase to a large extent. In a size design of the terminal device, improvement in a structure and a size of the terminal frame body is not affected, and the structure of the terminal frame body can be standardized, to facilitate production and assembly of the terminal device.

In a possible implementation, a light shielding part is disposed at an end that is of the conductor and that is close to the first assembly surface, and is configured to shield light transmitted from the display to the conductor, and the light shielding part is conductive.

In a possible implementation, in this implementation, the light shielding part is disposed on a side of the conductor. The light shielding part has a light shielding feature, and can block light transmitted from the display to the conductor, to prevent light reflection of the conductor from affecting imaging of the display. In addition, the light shielding part is further configured for the electrostatic charge to pass through, so that when electrostatic charges are gathered on an edge surface of the display, the electrostatic charges can pass through the light shielding part and be conducted to the conductor.

In a possible implementation, the light shielding part includes a light shielding layer, and the light shielding layer is coated on an outer side surface at the end that is of the conductor and that is close to the first assembly surface. Preparation is simple. A thickness of the light shielding layer can meet requirements for power-on and light shielding. The light shielding layer and the conductor are conductive.

In a possible implementation, a thickness of the light shielding part is less than 0.1 mm, to ensure that the thickness of the light shielding part is small for the electrostatic charge to pass through.

In a possible implementation, there are a plurality of conductors, and the plurality of conductors are sequentially arranged and spaced from each other, so that when the terminal frame body connects the display to the grounding electrode, the conductors perform covering in a length direction or a width direction of the display, and discharge, when an electrostatic charge is generated, the electrostatic charge in time.

In a possible implementation, the first assembly surface has a first opening, and the first opening communicates with the cavity, so that the conductor is directly connected to the display, or a cavity is spaced between the conductor and the display, and the electrostatic charge can be directly transmitted from the display to the conductor.

In a possible implementation, the conductor partially protrudes to an outer side of the first opening, or an end that is of the conductor and that is close to the first opening is coplanar with the first opening, so that when the first assembly surface is connected to the display, the conductor is in a contact connection to the display, and the electrostatic charges gathered on the display can be directly transferred to the conductor, and a transfer speed is fast.

In a possible implementation, an end that is of the conductor and that is close to the first opening is located in the cavity, a first sub-cavity is provided between the conductor and the first opening, and the first sub-cavity is a part of the cavity. The first sub-cavity can meet breakthrough of the electrostatic charge, prevent friction between the conductor and the display, and prevent the display from being in a contact connection to a sharp and hard conductor.

In a possible implementation, the electron isolation part has a first isolation part, and the first isolation part is located between the first assembly surface and the cavity, so that when the first assembly surface is connected to the display, the first isolation part is configured to isolate the conductor from the display, and electrically connect the conductor to the display. The first isolation part can isolate the conductor from the display, the conductor may be made of a metal conductor material, the display may be made of a fragile material such as glass, and the first isolation part can prevent the conductor from damaging the display.

In a possible implementation, the second assembly surface is configured to connect to the grounding electrode, the assembly surface has a second opening, and the second opening communicates the cavity, so that the conductor is directly connected to the grounding electrode, or a cavity is spaced between the conductor and the grounding electrode, and the electrostatic charge can be directly transmitted from the conductor to the grounding electrode.

In a possible implementation, the conductor partially protrudes to an outer side of the second opening, or an end that is of the conductor and that is close to the second opening is coplanar with the second opening, so that when the second assembly surface is connected to the grounding electrode, the conductor is in a contact connection to the grounding electrode, the electrostatic charges gathered on the conductor can be directly transferred to the grounding electrode, and a transfer speed is fast.

In a possible implementation, the end that is of the conductor and that is close to the second opening is located in the cavity, a second sub-cavity is provided between the conductor and the second opening, and the second sub-cavity is a part of the cavity. The second sub-cavity can meet breakthrough of the electrostatic charge, prevent friction between the conductor and the grounding electrode, and prevent the grounding electrode from being in a contact connection to a sharp and hard conductor.

In a possible implementation, the electron isolation part has a second isolation part, and the second isolation part is located between the grounding electrode and the conductor, so that when the second assembly surface is connected to the grounding electrode, the second isolation part isolates the conductor from the grounding electrode. The second isolation part can isolate the conductor from the grounding electrode, the conductor may be made of a metal conductor material, the grounding electrode may also be made of a metal conductor material, and the second isolation part 133 can prevent friction between the conductor and the grounding electrode.

According to a second aspect, this application provides a terminal device, including the terminal frame body according to any one of the foregoing implementations, and further including a display and a grounding electrode, where the display is connected to a first assembly surface of the terminal frame body, the grounding electrode is connected to a second assembly surface of the terminal frame body, and a conductor electrically connects the display to the grounding electrode. When an electrostatic charge is generated due to friction on an outer surface at an edge of the terminal device, the electrostatic charge is likely to move to an inner side of the display along an assembly gap between the display and the terminal frame body. When the electrostatic charge moves to the inside and is close to the conductor, the electrostatic charge is conducted to the conductor, and finally is conducted to the grounding electrode and is balanced, to avoid that the electrostatic charge moves to a sensitive component such as a circuit board in the display and an internal component of the mobile terminal is damaged due to the electrostatic charge.

In a possible implementation, the display includes an outer screen and an inner screen, a non-display region is between an edge of the outer screen and an edge of the inner screen, and a width of the non-display region is less than or equal to 1.5 mm. In this implementation, electrostatic charges gathered on the display are eliminated by using the conductor. No spacer such as an insulation adhesive is disposed between the frame body and the display. A width of a non-display region of the display can be set to be small, a proportion of an effective display area of the display increases, and display of the terminal device is more effective.

In a possible implementation, the grounding electrode includes an antenna and/or a metal middle frame member, and the antenna includes at least one of a middle frame metal integrated antenna, a flexible printed circuit antenna, and a laser direct structuring antenna.

In a possible implementation, there are at least two grounding electrodes, two of the grounding electrodes are respectively located on a left side and a right side of the terminal device, a conductor is disposed on each of the left side and the right side of the terminal device, and the grounding electrodes on the left side and the right side of the terminal device are both electrically connected to the display through an electrostatic discharge component. Conductors are disposed on both sides of the terminal device, and when electrostatic charges are generated on both the left side and the right side of the terminal device, the electrostatic charges can be quickly eliminated.

### BRIEF DESCRIPTION OF DRAWINGS

FIG. 1 is a diagram of a terminal device according to an implementation of this application;
FIG. 2 is a diagram of an A-A cross section of the terminal device shown in FIG. 1;
FIG. 3 is an enlarged diagram of a position I in FIG. 2;
FIG. 4 is a diagram of a partial structure of a terminal having a planar display according to an implementation of this application;
FIG. 5 is a diagram of a B-B cross section of a terminal device shown in FIG. 3;
FIG. 6 is a diagram of a cavity penetrating an electron isolation part according to an implementation of this application;
FIG. 7 is a diagram of a conductor protruding from an electron isolation part at two ends according to an implementation of this application;
FIG. 8 is a diagram of a conductor protruding from an electron isolation part at an upper end according to an implementation of this application;
FIG. 9 is a diagram of a conductor protruding from an electron isolation part at a lower end according to an implementation of this application;
FIG. 10 is a diagram in which two ends of a conductor are level with an outer surface of an electron isolation part according to an implementation of this application;
FIG. 11 is a diagram of structures of a first sub-cavity and a second sub-cavity according to an implementation of this application;
FIG. 12 is a diagram of a structure of a first isolation part according to an implementation of this application;
FIG. 13 is a diagram in which an upper end of a conductor is level with an outer surface of an electron isolation part according to an implementation of this application;
FIG. 14 is a diagram of a conductor protruding from an electron isolation part at an upper end according to an implementation of this application;
FIG. 15 is a diagram of a structure in which there is a second sub-cavity at an upper end of a conductor according to an implementation of this application;
FIG. 16 is a diagram of a structure of a second isolation part according to an implementation of this application;
FIG. 17 is a diagram in which a lower end of a conductor is level with an outer surface of an electron isolation part according to an implementation of this application;
FIG. 18 is a diagram of a conductor protruding from an electron isolation part at a lower end according to an implementation of this application;
FIG. 19 is a diagram of a structure in which there is a first sub-cavity at a lower end of a conductor according to an implementation of this application;
FIG. 20 is a diagram of a structure of an electron isolation part having both a first isolation part and a second isolation part according to an implementation of this application;
FIG. 21 is a diagram of a structure in which a conductor is located between a first isolation part and a second isolation part according to an implementation of this application; and
FIG. 22 is a diagram of a structure of a light shielding part according to an implementation of this application.

### DESCRIPTION OF EMBODIMENTS

The following describes embodiments of this application with reference to the accompanying drawings in embodiments of this application.

For ease of understanding, English abbreviations and related technical terms used in embodiments of this application are first explained and described below.

It should be noted that described embodiments are merely some rather than all of embodiments of this application. All other embodiments obtained by a person of ordinary skill in the art based on embodiments of this application without creative efforts shall fall within the protection scope of this application.

Terms used in embodiments of this application are merely intended to describe specific embodiments, but are not intended to limit this application. The terms "a", "said" and "the" of singular forms used in embodiments and the appended claims of this application are also intended to include plural forms, unless otherwise specified in the context clearly.

It should be understood that the term "and/or" in this specification is merely a same character for describing associated objects and represents that three relationships may exist. For example, A and/or B may represent the following three cases: Only A exists, both A and B exist, and only B exists. In addition, the character "/" in this specification generally indicates an "or" relationship between the associated objects.

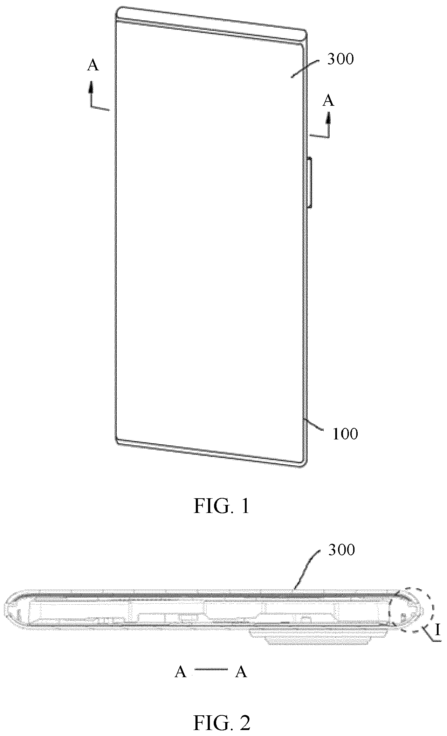

This application provides a terminal frame body. Refer to FIG. 1 to FIG. 3. The terminal frame body is disposed in a terminal device, and is configured to connect a display 300 to a grounding electrode 400 in the terminal device.

Refer to FIG. 1. The terminal device described in this application may be a mobile phone, or may be another input/output electronic product connected to a computer system, for example, a tablet computer or an intelligent wearable product. In this implementation, a mobile phone is used as an example for description, but the technical content in this application is also applicable to another terminal device.

The terminal device includes a housing assembled on an outer side of the terminal, and a circuit board located in the housing. The housing may include a display assembled on a front side of the terminal and a rear cover assembled on a rear side. The display 300 may include a glass panel and a display module (including a circuit board) disposed on an inner side of the glass panel. In an implementation of this application, the display 300 may be a touch display.

In some implementations of this application, the terminal device may further include a middle frame connected between the display 300 and the rear cover that are stacked. The display 300, the middle frame, and the rear cover jointly enclose enclosed space. Components such as a battery and a circuit board are disposed in the enclosed space. A specific manner of disposing the middle frame is not limited. The middle frame may be fused with the rear cover, or the middle frame may be disposed in the terminal device and connected in space enclosed by the display 300 and the rear cover.

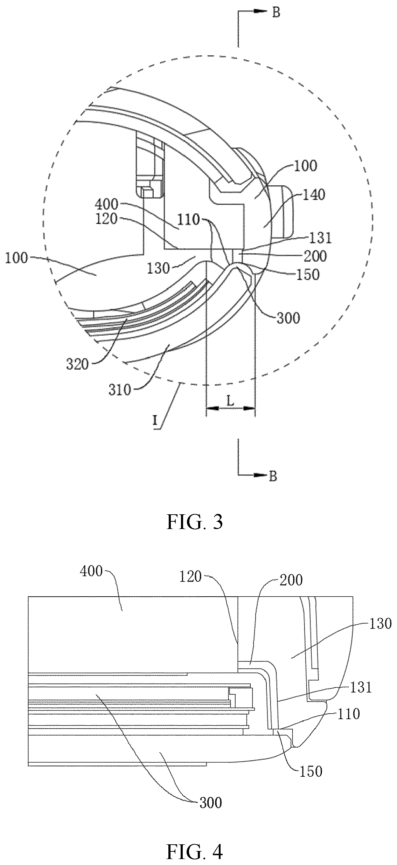

FIG. 2 is a sectional diagram of the mobile phone shown in FIG. 1 along A-A. FIG. 2 is a sectional diagram of the mobile phone. FIG. 3 is an enlarged diagram of a position I in FIG. 2, and is an enlarged diagram of a right end part in FIG. 2. FIG. 3 can display an internal structure of a right edge region of the mobile phone.

The terminal frame body may be a part of the middle frame, or may be another independent frame body other than the middle frame. Refer to FIG. 3. A plastic part structure in the middle frame is used as an example of the terminal frame body in this application, and the terminal frame body includes a frame body 100 and a conductor 200.

The frame body 100 is configured to connect the display 300 to the grounding electrode 400. A first assembly surface 110 is provided on the frame body 100, and the first assembly surface 110 may be a front-side assembly surface of the frame body 100. The front side described in this application means a direction in which the middle frame of the terminal device faces a screen, and the rear side means a direction in which the middle frame faces the rear cover (also referred to as a battery cover) of the terminal device. The first assembly surface 110 may be a part of an outer surface of the frame body 100. A shape of the first assembly surface 110 matches a shape of the display 300 in a connection position, so that an edge side surface of the display 300 is bonded to or in a spaced connection to the first assembly surface 110, and an assembly gap 150 is formed in the connection position. Specifically, in production and assembly processes of the terminal device, because the display 300 is mostly made of a fragile material such as glass, it is difficult to implement absolute bonding between an edge of the display 300 and the first assembly surface 110, and the assembly gap 150 is inevitably generated. The assembly gap 150 is small. Although dust, moisture, and the like can be prevented from passing through, an electrostatic charge may flow in the assembly gap 150, the electrostatic charge generated on an outer surface of the terminal device can enter the display 300 along the assembly gap 150, especially enter a circuit board of an inner screen of the display 300, and a short circuit is likely to occur, resulting in damage to a sensitive component such as the display 300. If the assembly gap 150 is filled with an insulation adhesive, to fill the assembly gap 150 to prevent the electrostatic charge from flowing to an inner side of the display 300, a thickness of the terminal device is increased. In addition, when the assembly gap 150 is filled with the insulation adhesive, a width of a non-display region of the display 300 is also increased. The non-display region of the display 300 is a black region on the periphery of an effective display region in the display 300. In a terminal such as a mobile phone, the non-display region is a black bezel around a screen, and is also referred to as a black edge. Filling the assembly gap 150 with the insulation adhesive increases a width of the black edge of the display 300, and affects imaging and aesthetics.

In addition, electrostatic charges gathered on an outer side surface of the display 300 may also pass through a part such as an outer screen of the display 300, and enter an internal circuit part of the display 300.

A second assembly surface 120 is further provided on the frame body 100. The second assembly surface 120 may be a rear-side outer surface of the frame body 100. A connection position between the grounding electrode 400 and the frame body 100 may alternatively be another position of the frame body 100. The second assembly surface 120 may alternatively be located in another direction of the frame body 100. In this implementation, an example in which the second assembly surface 120 is located in a rear side direction of the frame body 100 is used. The second assembly surface 120 may be a part of the outer surface of the frame body 100. A shape of the second assembly surface 120 matches a shape of the grounding electrode 400 in a connection position, so that the grounding electrode 400 is bonded to the second assembly surface 120.

Refer to FIG. 3. In this implementation, in the terminal device, a curved screen is used as an example. The first assembly surface 110 is a part of the outer surface of the frame body 100, and is configured to connect to an outer side surface at an edge of the display 300. The shape of the first assembly surface 110 matches an outer surface at an arc-shaped edge of the display 300. A side edge of the display 300 is bonded to the first assembly surface 110 of the frame body 100, and is relatively fastened to the first assembly surface 110.

In this implementation, the grounding electrode 400 may be an antenna in the terminal device, the grounding electrode 400 is located on a rear side of the frame body 100, the frame body 100 has the second assembly surface 120 on the rear side, and the second assembly surface 120 and the antenna are assembled and bonded.

In addition, in the terminal device described in this implementation, the frame body 100 may be an insulation part made of an insulation material such as plastic in the middle frame, and another frame body and a housing (for example, a back housing) of the terminal device are also made of an insulation material such as plastic.

An electron isolation part 130 is disposed between the first assembly surface 110 and the second assembly surface 120, and the electron isolation part 130 is at least a part of the frame body 100. The electron isolation part 130 is mostly made of a material such as plastic, and is insulative. A charge at a specific voltage cannot pass through the electron isolation part 130, to avoid that an electrostatic charge on the outer surface of the terminal device or a current generated by an internal component of the terminal passes through the electron isolation part 130 and reaches the display 300. The electron isolation part 130 is close to the assembly gap 150. Although the electron isolation part 130 can isolate a current generated by a circuit board (installed on a rear side surface of the frame body 100) and the like from being conducted to the inner side of the display 300, an electrostatic charge generated on an outer surface at an edge of the terminal device may be conducted to the inside of the display 300 along the assembly gap 150.

Specifically, in this implementation, a cavity 131 is provided in the electron isolation part 130, and the conductor 200 is disposed in the cavity 131. The conductor 200 is partially located in the assembly gap 150 or is in a spaced connection to the assembly gap 150. An end of the conductor 200 is located in the assembly gap 150. A charge in the assembly gap 150 can be in a direct contact connection to the conductor 200 and be conducted to the conductor 200. A spaced connection means that there is a specific spacing between the conductor 200 and the assembly gap 150, and the charge in the assembly gap 150 can break through the spacing and be conducted to the conductor 200. In addition, an end of the conductor 200 is in a contact connection to or in a spaced connection to the grounding electrode 400. Contact means that the conductor 200 is in a contact connection to the grounding electrode 400, and a charge in the conductor 200 can be directly conducted to the grounding electrode 400. A spaced connection means that there is a specific spacing between the conductor 200 and the grounding electrode 400, and the charge on the conductor 200 can break through the spacing and be conducted to the grounding electrode 400.

Two ends of the conductor 200 are respectively electrically connected to the display 300 and the grounding electrode 400, and the conductor 200 can conduct the charge in the assembly gap 150, to conduct the electrostatic charge in the assembly gap 150 to the grounding electrode 400. The grounding electrode 400 balances the electrostatic charge, and eliminates static electricity that occurs in the terminal device.

It should be noted that an electrical connection described in this application means that a charge may flow between two components, and the two components may be in a contact connection, may have a specific spacing, or may be indirectly connected through another component.

The terminal frame body in this implementation can connect the display 300 to the grounding electrode 400. When an electrostatic charge is generated at an outer edge of the terminal device, and the electrostatic charge is conducted to an inner side of the display 300 along the assembly gap 150, or the electrostatic charge is conducted to an inner side of the display 300 through a part of the frame body 100, the conductor 200 can intercept the electrostatic charge in time, and conduct the electrostatic charge to the grounding electrode 400 such as an antenna for charge balance. A volume of the terminal frame body described in this application does not change, a structure change is small, and a size and mass of the terminal device do not increase to a large extent. In a size design of the terminal device, improvement in a structure and a size of the terminal frame body is not affected, and the structure of the terminal frame body can be standardized, to facilitate production and assembly of the terminal device.

Refer to FIG. 4. In a possible implementation, when a part of the frame body in the terminal device is made of a metal material, for example, a part of the middle frame shown in FIG. 4 is made of an insulation material such as plastic, and the electron isolation part 130 may be made of an insulation material such as plastic. Another part of the middle frame is made of a metal material. In this case, the grounding electrode 400 may be a metal middle frame member, and the metal middle frame member is a metal part in the middle frame, for example, a metal antenna integrated into the middle frame. In this case, both the grounding electrode 400 and the frame body 100 are a part of a structure of the middle frame. The conductor 200 electrically connects the display 300 to the metal part of the middle frame, to conduct, to the metal part, electrostatic charges gathered on the screen, and balance and eliminate the electrostatic charges.

Specifically, the grounding electrode 400 may alternatively be another metal frame body, for example, a metal rear cover of the terminal device. A structure that can receive an electrostatic charge to balance and eliminate the electrostatic charge and a metal conductor that can be grounded to balance and eliminate an electrostatic charge in the terminal device each may be the grounding electrode 400 described in this application.

The antenna includes at least one of a middle frame metal integrated antenna, a flexible printed circuit antenna (FPC antenna), and a laser direct structuring antenna (LDS antenna).

Refer to FIG. 4. In this implementation, the display 300 is flat, and the edge of the display 300 is not bent toward a rear side of the terminal device. In this case, the electron isolation part 130 is connected to an edge part of the display 300, the electron isolation part 130 is located on a right side of a right edge of the display 300, and the display 300 has a part located on a lower side of the electron isolation part 130. The assembly gap 150 between the display 300 and the electron isolation part 130 includes a vertical part and a horizontal part, the horizontal part of the assembly gap 150 is close to the outer surface of the terminal device, and the conductor 200 is connected to the horizontal part of the assembly gap 150, to intercept the electrostatic charge and conduct the electrostatic charge to the grounding electrode 400 earlier. In this implementation, the cavity 131 in the electron isolation part 130 is curved, and the conductor 200 disposed in the cavity 131 is also curved.

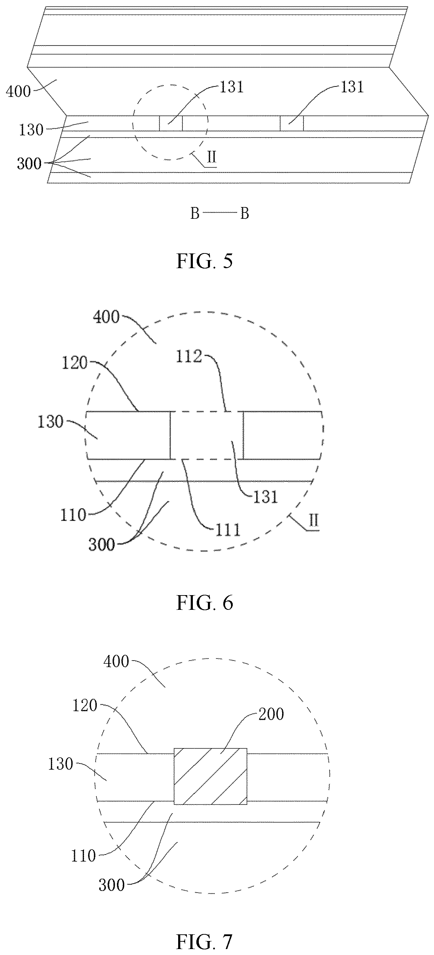

In a possible implementation, FIG. 5 is a diagram of a B-B cross section of the terminal device shown in FIG. 3. A left-right direction in FIG. 5 is consistent with a length direction of the terminal device. In this implementation, there are a plurality of conductors 200, there are also a plurality of cavities 131 that match the conductors 200, and the plurality of conductors 200 are sequentially arranged and spaced from each other.

An example in which the grounding electrode 400 in this implementation is an antenna is used, and the antenna extends in the terminal device in the length direction of the terminal device. For example, a height direction of the terminal device shown in FIG. 1 is the length direction of the terminal device. A plurality of cavities 131 are disposed in an extension direction of the antenna in the electron isolation part 130. A conductor 200 is disposed in each cavity 131, and the conductor 200 is configured to electrically connect the display 300 to the grounding electrode 400, to conduct an electrostatic charge at the edge of the display 300 to the antenna.

In this implementation, a plurality of conductors 200 may be disposed, and a quantity of and a spacing between the plurality of conductors 200 may be set based on lengths of the display 300 and/or the antenna, so that the plurality of conductors 200 can cover the display 300 and the antenna in the length direction of the terminal device. When an electrostatic charge is generated at the edge of the terminal device due to friction, the conductor 200 close to a region in which electrostatic charges are gathered can conduct the electrostatic charges to the antenna in time, and anti-static effect is better.

Refer to FIG. 1, FIG. 2, and FIG. 3. In a possible implementation, the conductor 200 shown in FIG. 3 is located in the right edge of the terminal device, and the conductor 200 is electrically connected between the right edge of the display 300 and the grounding electrode 400 (the antenna) on the right side of the terminal device.

When the grounding electrode 400 is also disposed in a left part of the terminal device, the conductor 200 is also disposed in a left region of the terminal device, and the conductor 200 is electrically connected between the left edge of the display 300 and the grounding electrode 400 (the antenna) on the left side of the terminal device.

Refer to FIG. 3. In a possible implementation, the frame body 100 includes an electron isolation part 130 and a frame part 140, and the electron isolation part 130 is close to the frame part 140.

The electron isolation part 130 is located in the terminal device. The electron isolation part 130 and the frame part 140 may be of an integrated structure, or may be of an integrated structure in which two independent parts are connected through a screw, an adhesive, or the like.

After the frame body 100, the display 300, the grounding electrode 400, a battery, a battery cover, and the like are assembled into the terminal device, the frame part 140 is located at an edge of the terminal device and is exposed on an outer side of the terminal device, and friction occurs between the frame part 140 and the outside to generate a specific electrostatic charge. The electrostatic charge that enters the display 300 can be conducted to the grounding electrode 400 by using the conductor 200.

Refer to FIG. 6. In a possible implementation, the first assembly surface 110 has a first opening 111, and the first opening 111 communicates with the cavity 131. The first opening 111 may be formed on the first assembly surface 110 while a groove or a through hole is formed on a side that is of the electron isolation part 130 and that faces the first assembly surface 110, to form the cavity 131.

Similarly, the second assembly surface 120 has a second opening 112, and the second opening 112 communicates with the cavity 131. The second opening 112 may be formed on the second assembly surface 120 while a groove or a through hole is formed on a side that is of the electron isolation part 130 and that faces the second assembly surface 120, to form the cavity 131.

Refer to FIG. 6 and FIG. 7. The conductor 200 located in the cavity 131 may protrude downward to an outer side of the first opening 111. When the first assembly surface 110 is connected to the display 300, the conductor 200 may be in a contact connection to the display 300, so that charges gathered in the assembly gap 150 between the display 300 and the first assembly surface 110 are in a direct contact connection to the conductor 200.

Refer to FIG. 6 and FIG. 7. In this implementation, the conductor 200 located in the cavity 131 may protrude upward to an outer side of the second opening 112. When the second assembly surface 120 is connected to the grounding electrode 400, the conductor 200 may be in a contact connection to the grounding electrode 400, so that the electrostatic charge can be directly conducted to the grounding electrode 400 by using the conductor 200.

According to a relative position relationship between the conductor 200, the display 300, and the grounding electrode 400 in this implementation, when the electrostatic charge is conducted to an inner side circuit board region of the display 300, the conductor 200 can conduct the electrostatic charge to the grounding electrode 400 in time, to prevent damage caused by a short circuit of a sensitive component such as an inner side circuit board of the display 300.

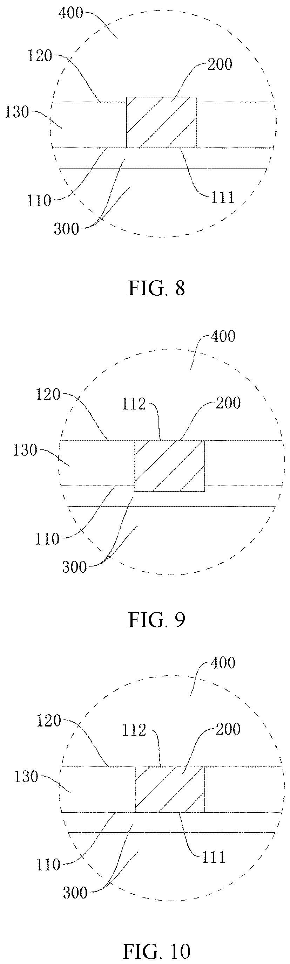

Refer to FIG. 6 and FIG. 8. In a possible implementation, the first assembly surface 110 has a first opening 111, and the second assembly surface 120 has a second opening 112.

The conductor 200 located in the cavity 131 may be coplanar with the first opening 111, that is, a lower side surface of the conductor 200 is level with the first assembly surface 110. When the display 300 is connected to the first assembly surface 110, the display 300 may be bonded to the first assembly surface 110, and the conductor 200 is also bonded to the display 300. Alternatively, a specific spacing is reserved between the display 300 and the first assembly surface 110, a specific spacing also exists between the conductor 200 and the display 300, and the spacing is small in width, so that charges gathered on an inner side surface of the display 300 can break through space air in the assembly gap 150, to implement an electrical connection between the display 300 and the conductor 200. When a charge is generated on the outer edge of the terminal device due to friction, the electrostatic charge is likely to be conducted along the inner side surface of the display 300 to the inside of the display 300. When the electrostatic charge is close to the conductor 200, the electrostatic charge can break through the assembly gap 150 to be conducted to the conductor 200, and finally be conducted to the grounding electrode 400 to balance the electrostatic charge.

The conductor 200 located in the cavity 131 may protrude upward to an outer side of the second opening 112. When the second assembly surface 120 is connected to the grounding electrode 400, the conductor 200 may be in a contact connection to the grounding electrode 400, so that the electrostatic charge can be directly conducted to the grounding electrode 400 by using the conductor 200. The conductor 200 can conduct the electrostatic charge to the grounding electrode 400 in time, to prevent damage caused by a short circuit of a sensitive component such as an inner side circuit board of the display 300.

Refer to FIG. 6 and FIG. 9. In a possible implementation, the first assembly surface 110 has a first opening 111, and the second assembly surface 120 has a second opening 112.

The conductor 200 located in the cavity 131 may protrude downward to an outer side of the first opening 111. When the first assembly surface 110 is connected to the display 300, the conductor 200 may be in a contact connection to the display 300, so that charges gathered in the assembly gap 150 between the display 300 and the first assembly surface 110 are in a direct contact connection to the conductor 200.

The conductor 200 located in the cavity 131 may be coplanar with the second opening 112, that is, an upper side surface of the conductor 200 is level with the second assembly surface 120. When the grounding electrode 400 is connected to the second assembly surface 120, the grounding electrode 400 may be bonded to the second assembly surface 120, and the conductor 200 is also bonded to the grounding electrode 400. Alternatively, a specific spacing may be reserved between the grounding electrode 400 and the second assembly surface 120, a specific spacing also exists between the conductor 200 and the grounding electrode 400, and the spacing is small in width. In this case, an electrostatic charge conducted by the conductor 200 can break through space air in the spacing. When a charge is generated on the outer edge of the terminal device due to friction, the electrostatic charge is likely to be conducted along the inner side surface of the display 300 to the inside of the display 300. When the electrostatic charge is close to the conductor 200, the electrostatic charge is conducted to the conductor 200, breaks through the spacing between the grounding electrode 400 and the conductor 200, and finally is conducted to the grounding electrode 400 to balance the electrostatic charge.

Refer to FIG. 6 and FIG. 10. In a possible implementation, the first assembly surface 110 has a first opening 111, and the second assembly surface 120 has a second opening 112.

The conductor 200 located in the cavity 131 may be coplanar with the first opening 111, that is, a lower side surface of the conductor 200 is level with the first assembly surface 110. When the display 300 is connected to the first assembly surface 110, the display 300 may be bonded to the first assembly surface 110, and the conductor 200 is also bonded to the display 300. Alternatively, a specific spacing may be reserved between the display 300 and the first assembly surface 110, a specific spacing also exists between the conductor 200 and the display 300, and the spacing is small in width. In this case, charges gathered on an inner side surface of the display 300 can break through space air in the assembly gap 150.

The conductor 200 located in the cavity 131 may be coplanar with the second opening 112, that is, an upper side surface of the conductor 200 is level with the second assembly surface 120. When the grounding electrode 400 is connected to the second assembly surface 120, the grounding electrode 400 may be bonded to the second assembly surface 120, and the conductor 200 is also bonded to the grounding electrode 400. Alternatively, a specific spacing may be reserved between the grounding electrode 400 and the second assembly surface 120, a specific spacing also exists between the conductor 200 and the grounding electrode 400, and the spacing is small in width. In this case, an electrostatic charge conducted by the conductor 200 can break through space air in the spacing. When a charge is generated on the outer edge of the terminal device due to friction, the electrostatic charge is likely to be conducted along the inner side surface of the display 300 to the inside of the display 300. When the electrostatic charge is close to the conductor 200, the electrostatic charge is conducted to the conductor 200, breaks through the spacing between the grounding electrode 400 and the conductor 200, and finally is conducted to the grounding electrode 400 to balance the electrostatic charge.

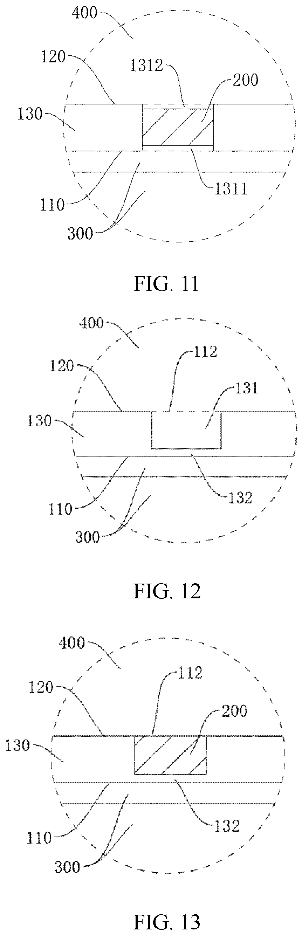

Refer to FIG. 6 and FIG. 11. In a possible implementation, the first assembly surface 110 has a first opening 111, and the second assembly surface 120 has a second opening 112.

An end that is of the conductor 200 and that is close to the first opening 111 is located in the cavity 131, a first sub-cavity 1311 is disposed between the conductor 200 and the first opening 111, and the first sub-cavity 1311 is a part of the cavity 131.

When the first assembly surface 110 is connected to the display 300, the first sub-cavity 1311 and an assembly gap 150 are spaced between the conductor 200 and the display 300. A gap distance between the first sub-cavity 1311 and the assembly gap 150 is small. For example, a sum of gap widths of the first sub-cavity 1311 and the assembly gap 150 is less than 1 mm, for example, 0.1 mm. The electrostatic charges gathered on the inner side surface of the display 300 can break through the first sub-cavity 1311 and the assembly gap 150, to implement an electrical connection between the display 300 and the conductor 200.

Alternatively, the first sub-cavity 1311 is filled with a conductive adhesive, so that the conductor 200 can be fastened in the cavity 131, is conductive, and can conduct the charge to the conductor 200 through the assembly gap 150 on the side of the display 300.

Specifically, an end that is of the conductor 200 and that is close to the second opening 112 is located in the cavity 131, a second sub-cavity 1312 is disposed between the conductor 200 and the second opening 112, and the second sub-cavity 1312 is a part of the cavity 131.

When the second assembly surface 120 is connected to the grounding electrode 400, the second sub-cavity 1312 is spaced between the conductor 200 and the grounding electrode 400. Alternatively, when there is a specific spacing between the grounding electrode 400 and the second assembly surface 120, the second sub-cavity 1312 and the spacing are spaced between the conductor 200 and the grounding electrode 400. In this implementation, an example in which the grounding electrode 400 is bonded to the second assembly surface 120 is used. A width of the second sub-cavity 1312 is less than 1 mm, for example, 0.1 mm. Refer to FIG. 11. Widths of the first sub-cavity 1311 and the second sub-cavity 1312 are heights in a height direction shown in FIG. 11. The electrostatic charge conducted by the conductor 200 can break through the second sub-cavity 1312, to implement an electrical connection between the grounding electrode 400 and the conductor 200.

It should be noted that an end that is of the conductor 200 and that is close to the first opening 111 may protrude from the first opening 111, may be coplanar with the first opening 111, or may be concave in the first opening 111 to form the first sub-cavity 1311. The conductor 200 can receive an electrostatic charge conducted on the side of the display 300 to implement an electrical connection. A relative position relationship between the conductor 200 and the display 300 may not be limited. An end that is of the conductor 200 and that is close to the second opening 112 may protrude from the second opening 112, may be coplanar with the second opening 112, or may be concave in the second opening 112 to form the second sub-cavity 1312. The conductor 200 can conduct a received electrostatic charge to the grounding electrode 400 to implement an electrical connection. A relative position relationship between the conductor 200 and the grounding electrode 400 may not be limited.

Refer to FIG. 12. In a possible implementation, the electron isolation part 130 further has a first isolation part 132, and the first isolation part 132 is located between the first assembly surface 110 and the cavity 131.

In this implementation, a part other than the first isolation part 132 in the electron isolation part 130 and the first isolation part 132 may be of an integrated structure, and the groove-shaped cavity 131 is formed in a direction in which the electron isolation part 130 faces the grounding electrode 400. The first isolation part 132 is a groove bottom of a groove structure in the electron isolation part 130, and a material of the part other than the first isolation part 132 in the electron isolation part 130 is the same as a material of the first isolation part 132. In this case, a thickness of the first isolation part 132 is small, for example, the thickness of the first isolation part 132 may be less than 0.1 mm, to ensure that electrostatic charges gathered on the outer surface of the display 300 can break through the first isolation part 132 and be electrically connected to the conductor 200, and the first isolation part 132 can isolate the conductor 200 from the display 300.

Alternatively, a through hole may be directly formed in the electron isolation part 130 to form structures of the first opening 111 and the second opening 112, and a bottom plate is fastened to the second opening 112, to form the first isolation part 132. In this case, the part other than the first isolation part 132 in the electron isolation part 130 and the first isolation part 132 are of split structures, and may be fastened through an adhesive or the like. In this case, the material of the part other than the first isolation part 132 in the electron isolation part 130 may be different from the material of the first isolation part 132, and the first isolation part 132 may be made of a conductive soft material, for example, a conductive layer formed by curing a conductive adhesive. The first isolation part 132 made of the conductive material can isolate the display 300 from the conductor 200 and electrically connect the display 300 to the conductor 200. In this application, that the first isolation part 132 isolates the conductor 200 from the display 300 means that the conductor 200 is not in a contact connection to the display 300, but is indirectly connected to the display 300 through the first isolation part 132. The first isolation part 132 isolates the conductor 200 from the display 300 to prevent the conductor 200 from being in a contact connection to the display 300. However, the electrostatic charge can break through the first isolation part 132, or the first isolation part 132 is conductive, so that the conductor 200 is electrically connected to the display 300 through the first isolation part 132.

The first isolation part 132 is located between the first assembly surface 110 and the cavity 131. In the terminal device, the first isolation part 132 is located between the conductor 200 and the display 300. The first isolation part 132 can isolate the conductor 200 from the display 300, the conductor 200 may be made of a metal conductor material, the display 300 may be made of a fragile material such as glass, and the first isolation part 132 can prevent the conductor 200 from damaging the display 300. In addition, electrostatic charges gathered on the outer surface of the display 300 can pass through the first isolation part 132 to reach the conductor 200, to discharge the electrostatic charges gathered on the outer surface of the display 300, and avoid that a sensitive component such as a circuit board in the display 300 is damaged due to impact of the electrostatic charge.

Refer to FIG. 13. In a possible implementation, the second assembly surface 120 has a second opening 112, and the second opening 112 communicates with the cavity 131.

The electron isolation part 130 includes a first isolation part 132. The first isolation part 132 is located between the first assembly surface 110 and the cavity 131. The first isolation part 132 isolates the conductor 200 from the display 300 and electrically connects the conductor 200 to the display 300. In this application, that the first isolation part 132 isolates the conductor 200 from the display 300 means that the conductor 200 is not in a contact connection to the display 300, but is indirectly connected to the display 300 through the first isolation part 132. The first isolation part 132 isolates the conductor 200 from the display 300 to prevent the conductor 200 from being in a contact connection to the display 300. However, the electrostatic charge can break through the first isolation part 132, or the first isolation part 132 is conductive, so that the conductor 200 is electrically connected to the display 300 through the first isolation part 132.

An end that is of the conductor 200 and that is close to the grounding electrode 400 may be coplanar with the second opening 112, so that an end that is of the conductor 200 and that is close to the second assembly surface 120 is coplanar with the second assembly surface 120. When the second assembly surface 120 is bonded to the grounding electrode 400, the conductor 200 is in a direct contact connection to the grounding electrode 400, so that the electrostatic charge is conducted between the conductor 200 and the grounding electrode 400.

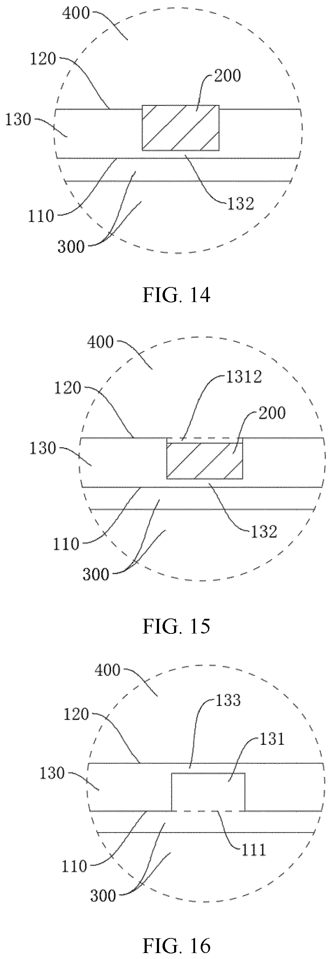

Refer to FIG. 14. Alternatively, an end that is of the conductor 200 and that is close to the grounding electrode 400 protrudes from the second opening 112, and a protruding part of the conductor 200 is in a direct contact connection to the grounding electrode 400, so that the electrostatic charge is conducted between the conductor 200 and the grounding electrode 400.

Refer to FIG. 15. Alternatively, an end that is of the conductor 200 and that is close to the grounding electrode 400 is located in the cavity 131, so that a second sub-cavity 1312 is formed between the conductor 200 and the second opening 112, and the second sub-cavity 1312 is a part of the cavity 131. When the second assembly surface 120 is assembled and connected to the grounding electrode 400, a width of the second sub-cavity 1312 may be less than 1 mm, for example, 0.1 mm, so that an electrostatic charge can break through air in internal space of the second sub-cavity 1312, and a charge collected by the conductor 200 can be transferred to the grounding electrode 400, so that the electrostatic charge is conducted between the conductor 200 and the grounding electrode 400.

Refer to FIG. 16. In a possible implementation, the electron isolation part 130 further has a second isolation part 133, and the second isolation part 133 is located between the second assembly surface 120 and the cavity 131.

In this implementation, a part other than the second isolation part 133 in the electron isolation part 130 and the second isolation part 133 may be of an integrated structure, the groove-shaped cavity 131 is formed in a direction in which the electron isolation part 130 faces the display 300, and the first opening 111 is formed on the first assembly surface 110. The second isolation part 133 is a groove bottom of a groove structure in the electron isolation part 130, and a material of the part other than the second isolation part 133 in the electron isolation part 130 is the same as a material of the second isolation part 133. In this case, a thickness of the second isolation part 133 is small, for example, the thickness of the second isolation part 133 may be less than 0.1 mm, to ensure that the electrostatic charge transferred by the conductor 200 can break through the second isolation part 133 and is electrically connected to the grounding electrode 400, and the second isolation part 133 can isolate the conductor 200 from the grounding electrode 400.

Alternatively, a through hole may be directly formed in the electron isolation part 130 to form structures of the second opening 112 and the first opening 111, and a bottom plate is fastened to the first opening 111, to form the second isolation part 133. In this case, the part other than the second isolation part 133 in the electron isolation part 130 and the second isolation part 133 are of split structures, and may be fastened through an adhesive or the like. In this case, the material of the part other than the second isolation part 133 in the electron isolation part 130 may be different from the material of the second isolation part 133, and the second isolation part 133 may be made of a conductive soft material, for example, a conductive layer formed by curing a conductive adhesive. The second isolation part 133 made of the conductive material can isolate the grounding electrode 400 from the conductor 200 and electrically connect the grounding electrode 400 to the conductor 200. In this application, that the second isolation part 133 isolates the conductor 200 from the grounding electrode 400 means that the conductor 200 is not in a contact connection to the grounding electrode 400, but is indirectly connected to the grounding electrode 400 through the second isolation part 133. The second isolation part 133 isolates the conductor 200 from the grounding electrode 400 to prevent the conductor 200 from being in a contact connection to the grounding electrode 400. However, the electrostatic charge can break through the second isolation part 133, or the second isolation part 133 is conductive, so that the conductor 200 is electrically connected to the grounding electrode 400 through the second isolation part 133.

The second isolation part 133 is located between the second assembly surface 120 and the cavity 131. In the terminal device, the second isolation part 133 is located between the conductor 200 and the grounding electrode 400. The second isolation part 133 can isolate the conductor 200 from the grounding electrode 400, the conductor 200 may be made of a metal conductor material, the grounding electrode 400 may also be made of a metal conductor material, and the second isolation part 133 can prevent friction between the conductor 200 and the grounding electrode 400. In addition, electrostatic charges gathered on the outer surface of the grounding electrode 400 can pass through the second isolation part 133 to reach the conductor 200, to discharge the electrostatic charges gathered on the outer surface of the grounding electrode 400, and avoid that a sensitive component such as a circuit board in the grounding electrode 400 is damaged due to impact of the electrostatic charge.

Refer to FIG. 16. In a possible implementation, the first assembly surface 110 has a first opening 111, and the first opening 111 communicates with the cavity 131.

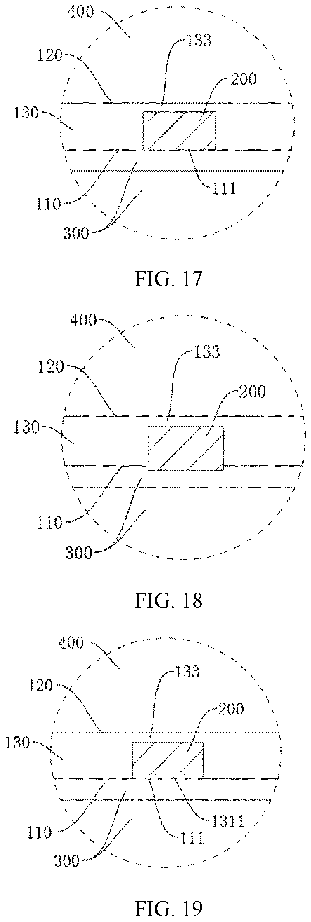

The electron isolation part 130 includes a second isolation part 133. The second isolation part 133 is located between the second assembly surface 120 and the cavity 131. Refer to FIG. 17 to FIG. 19. The second isolation part 133 isolates the conductor 200 from the grounding electrode 400 and electrically connects the conductor 200 to the grounding electrode 400. In this application, that the second isolation part 133 isolates the conductor 200 from the grounding electrode 400 means that the conductor 200 is not in a contact connection to the grounding electrode 400, but is indirectly connected to the grounding electrode 400 through the second isolation part 133. The second isolation part 133 isolates the conductor 200 from the grounding electrode 400 to prevent the conductor 200 from being in a contact connection to the grounding electrode 400. However, the electrostatic charge can break through the second isolation part 133, or the second isolation part 133 is conductive, so that the conductor 200 is electrically connected to the grounding electrode 400 through the second isolation part 133.

Refer to FIG. 17. An end that is of the conductor 200 and that is close to the display 300 may be coplanar with the first opening 111, so that an end that is of the conductor 200 and that is close to the first assembly surface 110 is coplanar with the first assembly surface 110. When the first assembly surface 110 is bonded to the display 300, the conductor 200 is in a direct contact connection to the display 300, so that the electrostatic charge is conducted between the conductor 200 and the display 300.

Refer to FIG. 18. Alternatively, an end that is of the conductor 200 and that is close to the display 300 protrudes from the first opening 111, and a protruding part of the conductor 200 is in a direct contact connection to the display 300, so that the electrostatic charge is conducted between the conductor 200 and the display 300.

Refer to FIG. 19. Alternatively, an end that is of the conductor 200 and that is close to the display 300 is located in the cavity 131, so that a first sub-cavity 1311 is formed between the conductor 200 and the first opening 111, and the first sub-cavity 1311 is a part of the cavity 131. When the first assembly surface 110 is assembled and connected to the display 300, a width of the first sub-cavity 1311 may be less than 1 mm, for example, 0.1 mm, so that an electrostatic charge can break through air in internal space of the first sub-cavity 1311, and a charge collected by the conductor 200 can be transferred to the display 300, so that the electrostatic charge is conducted between the conductor 200 and the display 300.

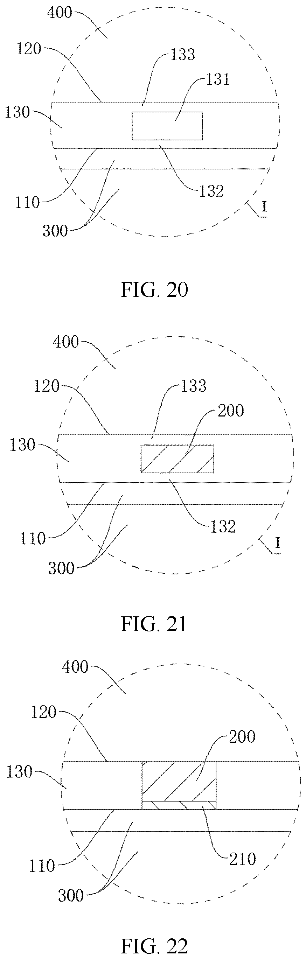

Refer to FIG. 20 and FIG. 21. In a possible implementation, the electron isolation part 130 has both a first isolation part 132 and a second isolation part 133, the cavity 131 is a cavity in the electron isolation part 130, and the cavity 131 has no opening structure on the first assembly surface 110 and the second assembly surface 120.

The conductor 200 is located in the cavity 131, and the conductor 200 is electrically connected to the display 300 through the first isolation part 132. The first isolation part 132 may be made of a flexible conductive material, or may be made of a flexible non-conductive material. For example, the first isolation part 132 is a part of the frame body 100, and a thickness of the first isolation part 132 may be less than 0.1 mm. The conductor 200 is electrically connected to the grounding electrode 400 through the second isolation part 133. The second isolation part 133 may be made of a flexible conductive material, or may be made of a flexible non-conductive material. For example, the second isolation part 133 is a part of the frame body 100, and a thickness of the second isolation part 133 may be less than 0.1 mm.

The electrostatic charge is conducted to an inner surface at the edge of the display 300, passes through the first isolation part 132 to be conducted to the conductor 200, and passes through the second isolation part 133 to be conducted to the grounding electrode 400.

Refer to FIG. 22. In a possible implementation, a light shielding part 210 is disposed at an end that is of the conductor 200 and that is close to the first assembly surface 110, and the light shielding part 210 can block light transmitted from the display 300 to the conductor 200, to prevent the conductor 200 from reflecting light to a side of the display 300.

Specifically, the conductor 200 is mostly made of white or silver metal, and light reflection occurs when light emitted from the display 300 is emitted to the conductor 200. This affects imaging of the display 300.

In this implementation, the light shielding part 210 is disposed on a side of the conductor 200. The light shielding part 210 has a light shielding feature, and can block light transmitted from the display 300 to the conductor 200, to prevent light reflection of the conductor 200 from affecting imaging of the display 300. In addition, the light shielding part 210 is further configured for the electrostatic charge to pass through, so that when electrostatic charges are gathered on an edge surface of the display 300, the electrostatic charges can pass through the light shielding part 210 and be conducted to the conductor 200.

Specifically, the light shielding part 210 may be made of a material that is conductive and has a light shielding feature, for example, a dark non-insulating material such as a black non-insulating material or a brown non-insulating material. The light shielding part 210 can block a light beam from passing through, but can ensure that an electrostatic charge is conducted. The light shielding part 210 may be a light shielding plate filled on a side that is of the conductor 200 and that is close to the display 300, or a light shielding layer coated on a side that is of the conductor 200 and that is close to the display 300. For example, the dark non-insulating material such as a black non-insulating material or a brown non-insulating material may be ink, and a possible mixed raw material is butanone, a metal complex dye, ethyl lactate, and the like.

When the light shielding part 210 is made of a metal conductive material, a thickness of the light shielding part 210 may not be limited; or when the light shielding part 210 is made of a non-conductive material, a thickness of the light shielding part 210 may be less than 0.1 mm, so that an electrostatic charge can break through the light shielding part 210, and the conductor 200 is electrically connected to the display 300.

This application further provides a terminal device. Refer to FIG. 1, FIG. 2, and FIG. 3. The terminal device includes the terminal frame body in any one of the foregoing implementations, and further includes a display 300 and a grounding electrode 400.

Specifically, the grounding electrode 400 may be an antenna in the terminal device, and the antenna is located in a right edge of the terminal device and extends in a length direction of the terminal device. In this implementation, the terminal frame body may be a middle frame, the display 300 is connected to a front side of the middle frame, the antenna is located on a rear side of the middle frame, the middle frame has a first assembly surface 110 and a second assembly surface 120, the first assembly surface 110 is connected to the display 300, the second assembly surface 120 is connected to the antenna, there is an electron isolation part 130 between the first assembly surface 110 and the second assembly surface 120, there is a cavity 131 on the electron isolation part 130, and the conductor 200 is located in the cavity 131. Specifically, the conductor 200 may be fastened in the cavity 131, to electrically connect the display 300 to the grounding electrode 400.

When an electrostatic charge is generated due to friction on an outer surface at an edge of the terminal device, the electrostatic charge is likely to move to an inner side of the display 300 along an assembly gap 150 between the display 300 and the terminal frame body. When the electrostatic charge moves to the inside and is close to the conductor 200, the electrostatic charge is conducted to the conductor 200, and finally is conducted to the grounding electrode 400 and is balanced, to avoid that the electrostatic charge moves to a sensitive component such as a circuit board in the display 300 and an internal component of the mobile terminal is damaged due to the electrostatic charge.

Refer to FIG. 1, FIG. 2, and FIG. 3. In a possible implementation, the grounding electrode 400 is located in the right edge of the terminal device, and the conductor 200 corresponding to the grounding electrode 400 is also located in the right edge of the terminal device.

Specifically, a grounding electrode 400 may also be disposed in a left edge of the terminal device. For example, antennas are disposed in both left and right edges of the terminal device, and both the antennas extend in a length direction of the terminal device. A conductor 200 is also disposed in the left edge of the terminal device, and the conductor 200 electrically connects the grounding electrode 400 on the left side to the display 300.

Refer to FIG. 3. In a possible implementation, the display 300 includes an outer screen 310 and an inner screen 320. The outer screen 310 is mostly made of a material such as glass, and a component such as a display panel is disposed on the inner screen 320, and the inner screen 320 is prone to damage due to impact of an electrostatic charge. Both the outer screen 310 and the inner screen 320 are of a plate structure, a region between an edge of the outer screen 310 and an edge of the inner screen 320 is a non-display region, and a width L of the non-display region is less than or equal to 1.5 mm. The outer screen 310 and the inner screen 320 are mostly quadrilateral, and a width L between any edge of the outer screen 310 and an edge that is of the inner screen 320 and that is close to the edge of the outer screen 310 is less than 1.5 mm. In this implementation, the conductor 200 is used to electrically connect the display 300 to the grounding electrode 400, and no component such as an insulation adhesive is disposed, so that a width of a spacing between the edge of the outer screen 310 and the edge of the inner screen 320 is reduced, a width of a black edge of a side of the display 300 can be effectively reduced, a display area proportion of the screen is larger, and the terminal device has better appearance aesthetics.

The foregoing embodiments are merely intended to describe the technical solutions of this application, but are not to limit this application.

## Claims

1. A terminal frame body, configured to connect a display (300) to a grounding electrode (400) in a terminal device, and comprising a frame body (100) and a conductor (200), wherein a first assembly surface (110) and a second assembly surface (120) are provided on the frame body (100), the first assembly surface (110) is configured to: connect to an outer edge of the display (300), and form an assembly gap (150), and the second assembly surface (120) is configured to connect to the grounding electrode (400);
an electron isolation part (130) is disposed between the first assembly surface (110) and the second assembly surface (120), the electron isolation part (130) is close to the assembly gap (150), the electron isolation part (130) is at least a part of the frame body (100), a cavity (131) is provided in the electron isolation part (130), and the conductor (200) is located in the cavity (131); and
the conductor (200) is partially located in the assembly gap (150) or is in a spaced connection to the assembly gap (150), and the conductor (200) is in a contact connection to or is in a spaced connection to the grounding electrode (400),
wherein a light shielding part (210) is disposed at an end that is of the conductor (200) and that is close to the first assembly surface (110), and is configured to shield light transmitted from the display (300) to the conductor (200), and the light shielding part (210) is conductive.

2. The terminal frame body according to claim 1, wherein the light shielding part (210) comprises a light shielding layer, and the light shielding layer is coated on an outer side surface at the end that is of the conductor (200) and that is close to the first assembly surface (110).

3. The terminal frame body according to claim 1 or 2, wherein a thickness of the light shielding part (210) is less than 0.1 mm.

4. The terminal frame body according to any one of claims 1 to 3, wherein there are a plurality of conductors (200), and the plurality of conductors (200) are sequentially arranged and spaced from each other.

5. The terminal frame body according to any one of claims 1 to 4, wherein the first assembly surface (110) has a first opening (111), and the first opening (111) communicates with the cavity (131).

6. The terminal frame body according to claim 5, wherein the conductor (200) partially protrudes to an outer side of the first opening (111), or an end that is of the conductor (200) and that is close to the first opening (111) is coplanar with the first opening (111), so that when the first assembly surface (110) is connected to the display (300), the conductor (200) is in a contact connection to the display (300).

7. The terminal frame body according to claim 5, wherein an end that is of the conductor (200) and that is close to the first opening (111) is located in the cavity (131), a first sub-cavity (1311) is provided between the conductor (200) and the first opening (111), and the first sub-cavity (1311) is a part of the cavity (131).

8. The terminal frame body according to any one of claims 1 to 4, wherein the electron isolation part (130) has a first isolation part (132), and the first isolation part (132) is located between the first assembly surface (110) and the cavity (131), so that when the first assembly surface (110) is connected to the display (300), the first isolation part (132) is configured to isolate the conductor (200) from the display (300), and electrically connect the conductor (200) to the display (300).

9. The terminal frame body according to any one of claims 1 to 8, wherein the second assembly surface (120) is configured to connect to the grounding electrode (400), the second assembly surface (120) has a second opening (112), and the second opening (112) communicates with the cavity (131).

10. The terminal frame body according to claim 9, wherein the conductor (200) partially protrudes to an outer side of the second opening (112), or an end that is of the conductor (200) and that is close to the second opening (112) is coplanar with the second opening (112), so that when the second assembly surface (120) is connected to the grounding electrode (400), the conductor (200) is in a contact connection to the grounding electrode (400).

11. The terminal frame body according to claim 10, wherein the end that is of the conductor (200) and that is close to the second opening (112) is located in the cavity (131), a second sub-cavity (1312) is provided between the conductor (200) and the second opening (112), and the second sub-cavity (1312) is a part of the cavity (131).

12. The terminal frame body according to any one of claims 1 to 8, wherein the electron isolation part (130) has a second isolation part (133), and the second isolation part (133) is located between the grounding electrode (400) and the conductor (200), so that when the second assembly surface (120) is connected to the grounding electrode (400), the second isolation part (133) isolates the conductor (200) from the grounding electrode (400).

13. A terminal device, comprising the terminal frame body according to any one of claims 1 to 12, and further comprising a display (300) and a grounding electrode (400), wherein
the display (300) is connected to a first assembly surface (110) of the terminal frame body, the grounding electrode (400) is connected to a second assembly surface (120) of the terminal frame body, and a conductor (200) electrically connects the display (300) to the grounding electrode (400).

14. The terminal device according to claim 13, wherein the display (300) comprises an outer screen (310) and an inner screen (320), a non-display region is between an edge of the outer screen (310) and an edge of the inner screen (320), and a width (L) of the non-display region is less than or equal to 1.5 mm.

15. The terminal device according to claim 13 or 14, wherein the grounding electrode (400) comprises an antenna and/or a metal middle frame member, and the antenna comprises at least one of a middle frame metal integrated antenna, a flexible printed circuit antenna, and a laser direct structuring antenna.

## Patentansprüche

1. Endgeräterahmenkörper, der dazu ausgelegt ist, eine Anzeige (300) in einer Endgerätevorrichtung mit einer Erdungselektrode (400) zu verbinden, und einen Rahmenkörper (100) und einen Leiter (200) umfasst, wobei eine erste Montagefläche (110) und eine zweite Montagefläche (120) an dem Rahmenkörper (100) vorgesehen sind, die erste Montagefläche (110) dazu ausgelegt ist, mit einem Außenrand der Anzeige (300) verbunden zu werden und einen Montagespalt (150) zu bilden, und die zweite Montagefläche (120) dazu ausgelegt ist, mit der Erdungselektrode (400) verbunden zu werden;
ein Elektronenisolationsteil (130) zwischen der ersten Montagefläche (110) und der zweiten Montagefläche (120) angeordnet ist, sich das Elektronenisolationsteil (130) nahe dem Montagespalt (150) befindet, das Elektronenisolationsteil (130) zumindest ein Teil des Rahmenkörpers (100) ist, ein Hohlraum (131) in dem Elektronenisolationsteil (130) vorgesehen ist und sich der Leiter (200) in dem Hohlraum (131) befindet; und
sich der Leiter (200) teilweise in dem Montagespalt (150) befindet oder von dem Montagespalt (150) beabstandet ist und der Leiter (200) mit der Erdungselektrode (400) in Kontakt steht oder von dieser beabstandet ist,
wobei ein Lichtabschirmungsteil (210) an einem Ende des Leiters (200), das sich nahe der ersten Montagefläche (110) befindet, angeordnet und dazu ausgelegt ist, von der Anzeige (300) zu dem Leiter (200) übertragenes Licht abzuschirmen, und das Lichtabschirmungsteil (210) leitfähig ist.

2. Endgeräterahmenkörper nach Anspruch 1, wobei das Lichtabschirmungsteil (210) eine Lichtabschirmungsschicht umfasst und die Lichtabschirmungsschicht auf einer äußeren Seitenfläche des Endes des Leiters (200), das sich nahe der ersten Montagefläche (110) befindet, aufgebracht ist.

3. Endgeräterahmenkörper nach Anspruch 1 oder 2, wobei eine Dicke des Lichtabschirmungsteils (210) weniger als 0,1 mm beträgt.

4. Endgeräterahmenkörper nach einem der Ansprüche 1 bis 3, wobei eine Mehrzahl von Leitern (200) vorhanden ist und die Mehrzahl von Leitern (200) aufeinanderfolgend angeordnet und voneinander beabstandet ist.

5. Endgeräterahmenkörper nach einem der Ansprüche 1 bis 4, wobei die erste Montagefläche (110) eine erste Öffnung (111) aufweist und die erste Öffnung (111) mit dem Hohlraum (131) in Verbindung steht.

6. Endgeräterahmenkörper nach Anspruch 5, wobei der Leiter (200) teilweise zu einer Außenseite der ersten Öffnung (111) vorsteht oder ein Ende des Leiters (200), das sich nahe der ersten Öffnung (111) befindet, in einer Ebene mit der ersten Öffnung (111) liegt, sodass der Leiter (200), wenn die erste Montagefläche (110) mit der Anzeige (300) verbunden ist, mit der Anzeige (300) in Kontakt steht.

7. Endgeräterahmenkörper nach Anspruch 5, wobei sich ein Ende des Leiters (200), das sich nahe der ersten Öffnung (111) befindet, in dem Hohlraum (131) befindet, ein erster Teilhohlraum (1311) zwischen dem Leiter (200) und der ersten Öffnung (111) vorgesehen ist und der erste Teilhohlraum (1311) ein Teil des Hohlraums (131) ist.

8. Endgeräterahmenkörper nach einem der Ansprüche 1 bis 4, wobei das Elektronenisolationsteil (130) einen ersten Isolationsteil (132) aufweist und sich der erste Isolationsteil (132) zwischen der ersten Montagefläche (110) und dem Hohlraum (131) befindet, sodass der erste Isolationsteil (132) bei Verbindung der ersten Montagefläche (110) mit der Anzeige (300) dazu ausgelegt ist, den Leiter (200) von der Anzeige (300) zu isolieren und den Leiter (200) elektrisch mit der Anzeige (300) zu verbinden.

9. Endgeräterahmenkörper nach einem der Ansprüche 1 bis 8, wobei die zweite Montagefläche (120) dazu ausgelegt ist, mit der Erdungselektrode (400) verbunden zu werden, die zweite Montagefläche (120) eine zweite Öffnung (112) aufweist und die zweite Öffnung (112) mit dem Hohlraum (131) in Verbindung steht.

10. Endgeräterahmenkörper nach Anspruch 9, wobei der Leiter (200) teilweise zu einer Außenseite der zweiten Öffnung (112) vorsteht oder ein Ende des Leiters (200), das sich nahe der zweiten Öffnung (112) befindet, in einer Ebene mit der zweiten Öffnung (112) liegt, sodass der Leiter (200), wenn die zweite Montagefläche (120) mit der Erdungselektrode (400) verbunden ist, mit der Erdungselektrode (400) in Kontakt steht.

11. Endgeräterahmenkörper nach Anspruch 10, wobei sich das Ende des Leiters (200), das sich nahe der zweiten Öffnung (112) befindet, in dem Hohlraum (131) befindet, ein zweiter Teilhohlraum (1312) zwischen dem Leiter (200) und der zweiten Öffnung (112) vorgesehen ist und der zweite Teilhohlraum (1312) ein Teil des Hohlraums (131) ist.

12. Endgeräterahmenkörper nach einem der Ansprüche 1 bis 8, wobei das Elektronenisolationsteil (130) einen zweiten Isolationsteil (133) aufweist und sich der zweite Isolationsteil (133) zwischen der Erdungselektrode (400) und dem Leiter (200) befindet, sodass der zweite Isolationsteil (133) bei Verbindung der zweiten Montagefläche (120) mit der Erdungselektrode (400) den Leiter (200) von der Erdungselektrode (400) isoliert.

13. Endgerätevorrichtung, umfassend den Endgeräterahmenkörper nach einem der Ansprüche 1 bis 12 und ferner eine Anzeige (300) und eine Erdungselektrode (400), wobei
die Anzeige (300) mit einer ersten Montagefläche (110) des Endgeräterahmenkörpers verbunden ist, die Erdungselektrode (400) mit einer zweiten Montagefläche (120) des Endgeräterahmenkörpers verbunden ist und ein Leiter (200) die Anzeige (300) elektrisch mit der Erdungselektrode (400) verbindet.

14. Endgerätevorrichtung nach Anspruch 13, wobei die Anzeige (300) einen äußeren Bildschirm (310) und einen inneren Bildschirm (320) umfasst, sich ein Nichtanzeigebereich zwischen einem Rand des äußeren Bildschirms (310) und einem Rand des inneren Bildschirms (320) befindet und eine Breite (L) des Nichtanzeigebereichs kleiner als oder gleich 1,5 mm ist.

15. Endgerätevorrichtung nach Anspruch 13 oder 14, wobei die Erdungselektrode (400) eine Antenne und/oder ein Metallmittelrahmenelement umfasst und die Antenne mindestens eine der folgenden Antennen umfasst: eine in einen Metallmittelrahmen integrierte Antenne, eine flexible Leiterplattenantenne und eine Laser-Direktstrukturierungsantenne.

## Revendications

1. Corps de cadre de terminal, configuré pour connecter un écran (300) à une électrode de mise à la masse (400) dans un dispositif terminal, et comprenant un corps de cadre (100) et un conducteur (200), une première surface d'assemblage (110) et une deuxième surface d'assemblage (120) étant pourvues sur le corps de cadre (100), la première surface d'assemblage (110) étant configurée pour être connectée à un bord extérieur de l'écran (300) et créer un espace d'assemblage (150), et la deuxième surface d'assemblage (120) étant configurée pour se connecter à l'électrode de mise à la masse (400) ;
une partie d'isolation électronique (130) étant disposée entre la première surface d'assemblage (110) et la deuxième surface d'assemblage (120), la partie d'isolation électronique (130) étant proche de l'espace d'assemblage (150), la partie d'isolation électronique (130) étant au moins une partie du corps de cadre (100), une cavité (131) étant ménagée dans la partie d'isolation électronique (130) et le conducteur (200) étant situé dans la cavité (131) ; et
le conducteur (200) étant partiellement situé dans l'espace d'assemblage (150) ou étant dans une connexion espacée de l'espace d'assemblage (150), et le conducteur (200) étant en connexion de contact avec l'électrode de mise à la masse (400) ou en connexion espacée avec celle-ci,
où une partie de blindage contre la lumière (210) est disposée à une extrémité du conducteur (200) et qui est proche de la première surface d'assemblage (110), et est configurée pour protéger la lumière transmise par l'affichage (300) au conducteur (200), et la partie de blindage contre la lumière (210) est conductrice.

2. Corps de cadre de terminal selon la revendication 1, dans lequel la partie de blindage contre la lumière (210) comprend une couche de blindage contre la lumière, et la couche de blindage contre la lumière est revêtue sur une surface latérale extérieure à l'extrémité du conducteur (200) et qui est proche de la première surface d'assemblage (110).

3. Corps de cadre de terminal selon la revendication 1 ou la revendication 2, dans lequel une épaisseur de la partie de blindage contre la lumière (210) est inférieure à 0,1 mm.

4. Corps de cadre de terminal selon l'une quelconque des revendications 1 à 3, dans lequel il y a une pluralité de conducteurs (200), et la pluralité de conducteurs (200) sont agencés de manière séquentielle et espacés les uns des autres.

5. Corps de cadre de terminal selon l'une quelconque des revendications 1 à 4, dans lequel la première surface d'assemblage (110) a une première ouverture (111), et la première ouverture (111) communique avec la cavité (131).

6. Corps de cadre de terminal selon la revendication 5, dans lequel le conducteur (200) fait partiellement saillie vers un côté extérieur de la première ouverture (111), ou une extrémité du conducteur (200) et qui est proche de la première ouverture (111) est coplanaire avec la première ouverture (111), de sorte que lorsque la première surface d'assemblage (110) est connectée à l'affichage (300), le conducteur (200) est en connexion de contact avec l'écran d'affichage (300).

7. Corps de cadre de terminal selon la revendication 5, dans lequel une extrémité du conducteur (200) et qui est proche de la première ouverture (111) est située dans la cavité (131), une première sous-cavité (1311) est pourvue entre le conducteur (200) et la première ouverture (111), et la première sous-cavité (1311) est une partie de la cavité (131).

8. Corps de cadre de terminal selon l'une quelconque des revendications 1 à 4, dans lequel la partie d'isolation électronique (130) a une première partie d'isolation (132), et la première partie d'isolation (132) est située entre la première surface d'assemblage (110) et la cavité (131), de sorte que lorsque la première surface d'assemblage (110) est connectée à l'affichage (300), la première partie d'isolation (132) est configurée pour isoler le conducteur (200) de l'affichage (300), et connecter électriquement le conducteur (200) à l'écran d'affichage (300).

9. Corps de cadre de terminal selon l'une quelconque des revendications 1 à 8, dans lequel la deuxième surface d'assemblage (120) est configurée pour se connecter à l'électrode de mise à la masse (400), la deuxième surface d'assemblage (120) ayant une deuxième ouverture (112), et la deuxième ouverture (112) communiquant avec la cavité (131).

10. Corps de cadre de terminal selon la revendication 9, dans lequel le conducteur (200) fait partiellement saillie vers un côté extérieur de la deuxième ouverture (112), ou une extrémité du conducteur (200) et qui est proche de la deuxième ouverture (112) est coplanaire avec la deuxième ouverture (112), de sorte que lorsque la deuxième surface d'assemblage (120) est connectée à l'électrode de mise à la masse (400), le conducteur (200) est en connexion de contact avec l'électrode de mise à la masse (400).

11. Corps de cadre de terminal selon la revendication 10, dans lequel l'extrémité du conducteur (200) et qui est proche de la deuxième ouverture (112) est située dans la cavité (131), une deuxième sous-cavité (1312) est pourvue entre le conducteur (200) et la deuxième ouverture (112), et la deuxième sous-cavité (1312) est une partie de la cavité (131).

12. Corps de cadre de terminal selon l'une quelconque des revendications 1 à 8, dans lequel la partie d'isolation électronique (130) a une deuxième partie d'isolation (133), et la deuxième partie d'isolation (133) est située entre l'électrode de mise à la masse (400) et le conducteur (200), de sorte que, lorsque la deuxième surface d'assemblage (120) est connectée à l'électrode de mise à la masse (400), la deuxième partie d'isolation (133) isole conducteur (200) de l'électrode de mise à la masse (400).

13. Dispositif terminal, comprenant le corps de cadre de terminal selon l'une quelconque des revendications 1 à 12, et comprenant en outre un affichage (300) et une électrode de mise à la masse (400), où
l'affichage (300) est connecté à une première surface d'assemblage (110) du corps de cadre de terminal, l'électrode de mise à la masse (400) est connectée à une deuxième surface d'assemblage (120) du corps de cadre de terminal, et un conducteur (200) connecte électriquement l'affichage (300) à l'électrode de mise à la masse (400).

14. Dispositif terminal selon la revendication 13, dans lequel l'affichage (300) comprend un écran extérieur (310) et un écran intérieur (320), une région de non affichage est située entre un bord de l'écran extérieur (310) et un bord de l'écran intérieur (320), et une largeur (L) de la région de non affichage est inférieure ou égale à 1,5 mm.

15. Dispositif terminal selon la revendication 13 ou la revendication 14, dans lequel l'électrode de mise à la masse (400) comprend une antenne et/ou un élément de cadre métallique central, et l'antenne comprend au moins l'une d'une antenne métallique intégrée au cadre central, d'une antenne à circuit imprimé flexible et d'une antenne à structuration directe laser.
